Europäisches Patentamt

European Patent Office

Office européen des brevets

(11) Veröffentlichungsnummer: **0 303 049**

**A2**

## (12) EUROPÄISCHE PATENTANMELDUNG

(21) Anmeldenummer: 88110885.6

(22) Anmeldetag: 07.07.88

(51) Int. Cl.⁴: **H01L 27/14**

(30) Priorität: **10.08.87 DE 3726569**

(43) Veröffentlichungstag der Anmeldung:
**15.02.89 Patentblatt 89/07**

(84) Benannte Vertragsstaaten:
**AT BE CH DE FR GB IT LI LU NL**

(71) Anmelder: **Siemens Aktiengesellschaft Berlin
und München
Wittelsbacherplatz 2
D-8000 München 2(DE)**

(72) Erfinder: **Rosan, Karlheinz
Auenstrasse 44
D-8000 München 5(DE)**

(54) Optoelektronische Bildsensoranordnung.

(57) Auf einem Substrat in Zeilen angeordnete Dünnschicht-Photodioden (1 bis 8) sind über unterschiedlich lange, parallel laufende Dünnschicht-Leiterbahnen (L1 bis L8) mit auf dem gleichen Substrat angeordneten Auslesechips (CH) verbunden. Zum Ausgleich der Leiterbahnkapazitäten bei unterschiedlich langen benachbarten Leiterbahnen (L4 bis L7) sind in einem oder mehrere Leiterbahnteilstücken ihre Breiten kleiner oder größer dimensioniert, so daß die Summe der Koppelkapazitäten aller Teilstücke zweier benachbarter Leiterbahnen unabhängig von der Gesamtlänge stets denselben Wert besitzt. Die Erfindung beseitigt die durch die unterschiedlichen Längen der Ausleseleitungen bedingten Inhomogenitäten im Sensorsignal; die Erfindung wird angewandt für optoelektronische Lesegeräte, insbesondere in der Büroautomation.

FIG 2

EP 0 303 049 A2

## Optoelektronische Bildsensoranordnung.

Die Erfindung betrifft eine optoelektronische Bildsensoranordnung, bei der Dünnschicht-Photodioden auf einem Substrat in Zeilen angeordnet sind und über unterschiedlich lange, parallel laufende Dünnschicht-Leiterbahnen mit auf dem gleichen Substrat angeordneter Ausleseschaltung verbunden sind, so daß die durch das von der Bildvorlage reflektierte Licht in den Photodioden erzeugten Ladungsträger als elektrische Signale ausgelesen werden können.

Die moderne Kommunkation und Büroautomation benötigt Lesegeräte, welche Texte, aber auch Graphiken und Bilder von einem Blatt Papier aufnehmen und in einen Computer einlesen können.

Hierzu wird seit einiger Zeit an der Entwicklung optoelektronischer Zeilensensoren für die Bildaufnahme gearbeitet, mit denen solche Vorlagen ohne optische Verkleinerung gelesen werden können. Derartige Zeilensensoren können in einer Hybrid-Technik hergestellt werden, bei der Dünnschicht-Photodioden in einer Reihe angeordnet und über Dünnschicht-Leiterbahnen mit Auslesechips verbunden werden. Nähere Einzelheiten über den Aufbau und die Eigenschaften eines Bildsensors auf der Basis von amorphem, wasserstoffhaltigem Silizium (a-Si:H) ist aus einem Bericht von K. Kempter aus den Proceedings of the Society of Photo-Optical Instrumentation Engineers, Vol. 617 Amorphous Semiconductors for Microelectronics (1986), Seiten 120 bis 126, zu entnehmen.

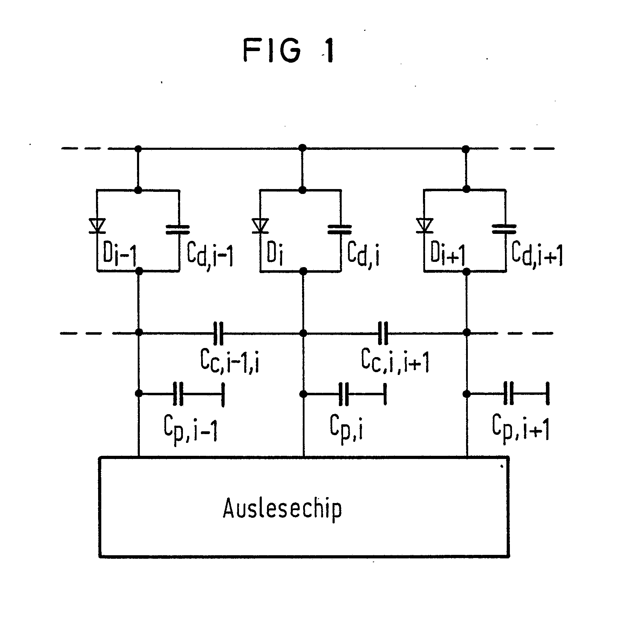

Das von der Vorlage reflektierte Licht erzeugt Ladungsträger in den Photodioden. Beim Integrationsverfahren werden die Ladungsträger über eine gewisse Zeit (Integrationszeit) in Speicherkapazitäten gesammelt und am Ende dieser Integrationszeit mit der Ausleseschaltung ausgelesen. Figur 1 zeigt ein Ersatzschaltbild, welches die für die Signalbildung wesentlichen Kapazitäten ent hält. Die Speicherkapazität für jede Photodiode wird gebildet durch die Photodiodenkapazität ($C_d$) selbst, die Kapazität des zugehörigen Eingangs der Ausleseschaltung und durch die Kapazitäten der Ausleseleitung ($C_p$ und $C_c$). Die Signalspannung an den Photodioden ist bei vorgegebener Signalladung umgekehrt proportional zur Größe der Speicherkapazität. Da die Kapazitäten der Leiterbahnen Teil der Speicherkapazitäten sind, führen unterschiedliche Längen der Ausleseleitungen zu entsprechenden Inhomogenitäten im Sensorsignal. Die Lichtempfindlichkeit des Sensors, das Übersprechen zwischen benachbarten Elementen und damit verbunden die Modulations-Übertragung (MÜF) sind dann ortsabhängig. Nähere Einzelheiten über den Einfluß der Leiterbahnkapazitäten auf das Sensorsignal sind dem Bericht von Rosan et al. aus dem Konferenzband der IEEE Conf. on Photo Electronic Imaging, London, 1985, Nr. 253, Seiten 92 bis 95, zu entnehmen.

Aufgabe der Erfindung ist es nun, die durch die unterschiedliche Länge der Ausleseleitungen bedingten Signalinhomogenitäten zu beseitigen.

Bisher wurde dieses Problem noch nicht zufriedenstellend gelöst. Der Verlauf der Leiterbahnen ist weitgehend durch die Abmessungen der vorzugsweise auf einem Chip integrierten Ausleseschaltung, deren Pad-Anordnung und durch die Zahl der Photodioden pro mm vorgegeben. Die unterschiedliche Länge der Ausleseleitungen ergibt sich zwangsläufig aus der im Vergleich zu den Photodioden geringeren Dichte der Bondpads auf den Auslesechips, wie aus der Figur 1 in dem Bericht von Rosan und Brunst im Tagungsband der 1986 Materials Research Society Symposium Proceedings Vol. 70, Seiten 683 bis 688, zu entnehmen ist.

In der europäischen Patentanmeldung 0 148 620 wird dieses Problem für einen Bildsensor behandelt, bei dem eine Groundplane (geerdete metallische Abschirmschicht) die Leiterbahnen ganz oder teilweise, getrennt durch eine Isolatorschicht, überdeckt. Leiterbahn und Groundplane bilden dann eine Art Plattenkondensator. Zwischen jeder Leiterbahn und der Groundplane entsteht dadurch eine Streukapazität, die umso größer ist, je länger die Leitung ist. In diesem Fall muß, zum Ausgleich der daraus resul tierenden Signalinhomogenitäten, die Summe aller mit einer Zelle verbundenen Streukapazitäten gleichgroß gemacht werden. Hierzu wird vorgeschlagen, die Fläche aller Leiterbahnen gleichgroß zu machen, bzw. den Kapazitätsausgleich über eine, mit der Zelle verbundene, nicht beleuchtete, zusätzliche Überlappkapazität durchzuführen.

Die vorliegende Erfindung löst das Problem der Signalinhomogenitäten infolge Leiterbahnkopplung bei einem Bildsensor der eingangs genannten Art dadurch, daß zum Ausgleich der Leiterbahnkoppelkapazitäten bei unterschiedlich langen benachbarten Leiterbahnen in einem oder mehreren Leiterbahnteilstücken ihre Breiten größer oder kleiner dimensioniert sind, so daß die Summe der Koppelkapazitäten aller Teilstücke zweier benachbarter Leiterbahnen unabhängig von der Gesamtlänge stets denselben Wert besitzen.

Folgende Überlegungen haben zu der Erfindung geführt:

Die gegenseitige kapazitive Kopplung zweier paralleler Leiterbahnen mit der Länge l, der Breite b und dem Abstand a zwischen den Leiterbahnen ergibt sich aus der folgenden Beziehung:

$$C = \frac{\varepsilon_o \cdot 1}{2} (1 + \varepsilon_{\gamma}) \frac{K(k')}{K(k)} \qquad (1)$$

$$\text{wobei } k = \frac{a}{2b+a} \quad \text{und } k' = \sqrt{1-k^2}.$$

Dabei sind $K(k)$ und $K(k')$ vollständige elliptische Integrale erster Gattung und $\varepsilon_o$ bzw. $\varepsilon_{\gamma}$ die Dielektrizitätskonstante des Vakuums bzw. des Trägermaterials.

Die Dicke der Leitungen hat in erster Näherung (Dünnschichttechnik) keinen Einfluß auf die Koppelkapazitäten.

Bei einem vorgegebenen Verlauf der Leiterbahnen sind die Mittenabstände der Leiterbahnteilstücke festgelegt. Bei einem festen Mittenabstand m zweier paralleler Leiterbahnstücke hängt die Größe k dann nur noch von der Leiterbahnbreite b ab:

$$k = \frac{m-b}{m+b} \qquad (2)$$

Die Koppelkapazität ist in diesem Fall nur noch eine Funktion der Länge und der Breite:

$$C = C(l,b) \qquad (3)$$

Die Koppelkapazität zweier unterschiedlich langer gerader Leiterbahnpaare kann nun bei festgehaltener Breite des einen Leiterbahnpaares, über eine nach (3) zu berechnende Breite für das zweite Leiterbahnpaar gleichgroß gemacht werden.

Die Koppelkapazität einer Leiterbahn in einem abknickenden Leiterbahnbus errechnet sich aus der Summe der Koppelkapazitäten der Leiterbahnteilstücke:

$$C = \sum_i C_i (l_i, b_i) \qquad (4)$$

Damit ergibt sich die Möglichkeit unterschiedliche Koppelkapazitäten benachbarter Leitungen über eine größere oder kleinere Breite von einem oder mehreren Leiterbahnteilstücken so auszugleichen, daß die Summe der Koppelkapazitäten aller Teilstücke zweier benachbarter Leiterbahnen unabhängig von der tatsächlichen Gesamtlänge stets denselben Wert liefert.

Ähnliche Kapazitäts-Berechnungen aber mit dem Ergebnis, daß zur Erzielung gleicher Kapazitäten die Leiterbahnen gleiche Längen besitzen müssen, was aber schwierig wegen der Anforderung an die Auflösung zu realisieren ist, wurden in einem Bericht von Seki et. al. im IEEE Transactions on Components, Hybrids and Manufacturing Technology, Vol. CHMT9, Nr. 3, September 1986, auf den Seiten 304 bis 309, angestellt. Das der Erfindung zugrundeliegende Prinzip, den Einfluß der Leiterbahnlänge auf die Koppelkapazität über die Leiterbahnbreite zu kompensieren, ist weder den Berechnungen von Seki noch den in der europäischen Patentanmeldung 0 148 620 getroffenen Feststellungen zu entnehmen.

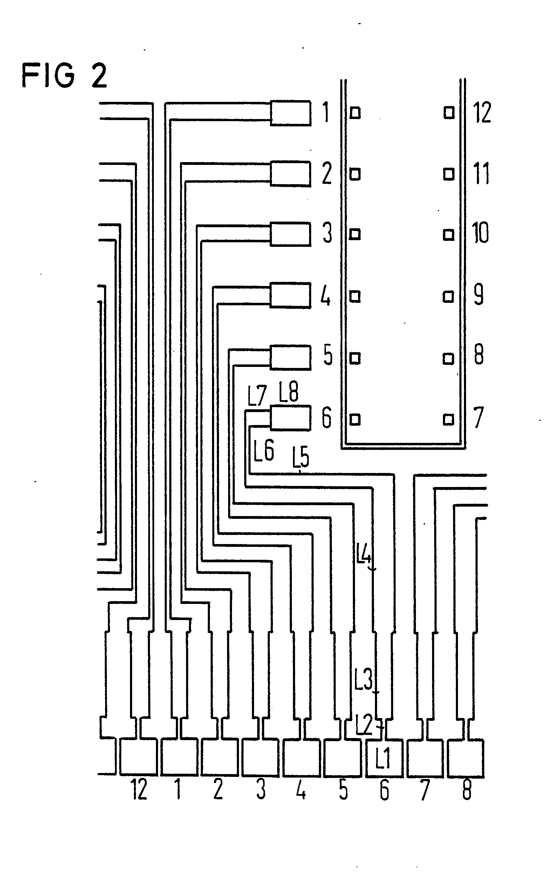

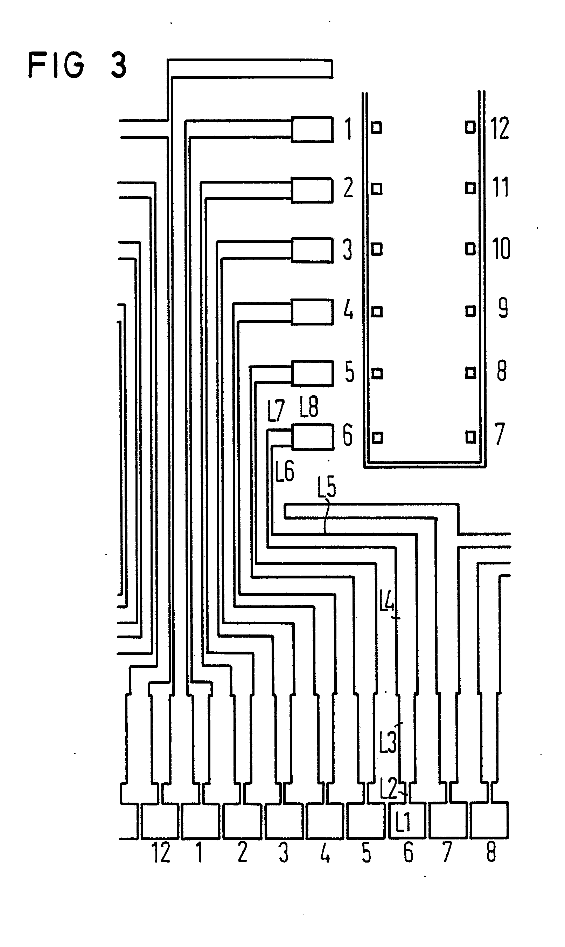

Weitere Ausgestaltungen der Erfindung ergeben sich aus den Unteransprüchen sowie nachfolgend bei der Beschreibung eines Ausführungsbeispiels anhand der Figuren 2 und 3, welche schematisch den Verlauf der Leiterbahnen zwischen einer Photodiodenzeile und einem Chip mit je sechs Eingängen pro Längsseite zeigen.

Die Figur 2 ist ein Ausschnitt eines 4-Zoll-Funktionsmusters eines a-Si:H-Hybridzeilensensors mit der Bezeichnung OSCAR 2B. Ein solcher Sensor ist beschrieben in dem eingangs erwähnten Bericht von Rosan und Brunst. Die verwendeten Auslesechips weisen hier pro Längsseite 64 Eingänge auf. Das Leiterbahnmuster der Ausleseleitungen zwischen Photodioden-Array und chipseitigen Bondpads ist symmetrisch zur Längsachse der Chips. Die Leiterbahnen verlaufen, beginnend bei den a-Si:H-Sensorelementen, zunächst alle parallel, wobei die Leiterbahndichte der Sensorelementdichte entspricht. In unterschiedlichen Abständen von den Sensorelementen knicken die Leiterbahnen ab und werden zur Chiplängsseite geführt. Zwischen den Chips nimmt die Leiterbahndichte zu, um Platz für die Chips zu schaffen. Alle Leitungen einer Chiphälfte haben verschiedene Längen. Die maximale und die minimale Leiterbahnlänge unterscheiden sich bei dem hier vorgestellten Muster um den Faktor 2.3.

Figur 2:

Die einzelnen Leiterbahnstücke wurden hier, beginnend mit der Grundelektrode der Photodiode, von LI bis L8 (= bond pad) durchnumeriert. Von Leiterbahn zu Leiterbahn unterschiedliche Längen haben die Teilstücke L4 bis L7. Die Teilstücke LI bis L3, sowie das bond pad L8 bleiben in der Länge gleich und liefern daher stets denselben additiven Beitrag zur Leiterbahnkapazität.

Die Länge der Leiterbahnstücke L4 nimmt mit aufsteigender Leiterbahnnummer jeweils um den Mittenabstand (Leiterbahnraster) R5 der Leiterbahnstücke L5 zu und L5 um R4, dagegen nimmt L6 um R5 + R7 und L7 um R6 ab. Die Gesamtlänge ändert sich also jeweils um denselben Betrag.

Da nach Gleichung (I) die Kapazität direkt proportional zur Länge ist, ist bei konstanter Längenänderung auch die Änderung $\Delta$ C der gesamten Leiterbahnkapazität $C_{ges}$ konstant.

$$\Delta C = R5 \times C'(R4,B4) + R4 \times C'(R5,B5) - (R5 + R7) \times C'(B6,R6) - R6 \times C'(B7,R7) \qquad (2)$$

wobei

$$C' = C/l \qquad (3)$$

die Kapazität pro Längeneinheit bezeichnet.

In Tabelle I sind die Koppelkapazitäten der Leiterbahnen beim Funktionsmuster OSCAR 2B mit dem bekannten Design aufgelistet.

Neben der Leiterbahnnummer finden sich die Koppelkapazitäten C4 bis C7 der in der Länge unterschiedlichen Leiterbahnteilstücke L4 bis L7, sowie unter $C_{ges}$ deren Summe. Darüber stehen die Breite B und der Mittenabstand (Raster) R des jeweiligen Leiterbahnteilstückes. Berechnet wurde jeweils die Kopplung zwischen der Leiterbahn mit der Nummer N und der Nummer N - I.

Mit zunehmender Leiterbahnnummer nimmt die Kapazität von Nr. 2 nach Nr. 64 ab. Die Koppelkapazität $C_{ges}$ zwischen Leitung I und 2 beträgt hier 785 fF, zwischen Leitung 63 und 64 aber nur 469 fF, ist also 0,6 fach kleiner.

Die Kapazität zwischen Leitung I und 2 rührt im wesentlichen von dem Leiterbahnstück L6, wohingegen der Hauptbeitrag beim Leiterbahnpaar 63 und 64 von L4 stammt. Es bietet sich daher an, die Abnahme von C6 durch eine entsprechende Zunahme von C4 zu kompensieren. Mit der Forderung C = 0, erhält man aus (2):

$$C'(R4,B4) = ((R5 + R7) \times C'(B6,R6) + R6 \times C'(B7,R7) - R4 \times C'(B5,R5)/R5 \qquad (4)$$

Da das Raster R4 durch die Sensorelementdichte festgelegt ist, muß in diesem Fall die Kompensation über die Leiterbahnbreite durchgeführt werden. Die ursprüngliche Breite für B4 von 40 μm ist dann auf den mit (I) und (4) neu berechneten Wert von 58,6 μm zu erhöhen. Das Ausführungsbeispiel wurde mit 59 μm gerechnet, da das zur Verfügung stehende Designsystem nur ganze μm- Einheiten zuläßt. Im Ausführungsbeispiel wurde die Leiterbahn breite B4 zum Kapazitätsausgleich berechnet; dies ist ebenfalls für die andere Leiterbahnbreite möglich. Außerdem läßt sich auch diesbezüglich eine Veränderung des Rasters vornehmen.

In Tabelle 2 sind die Koppelkapazitäten der Leiterbahnen beim Funktionsmuster OSCAR 2B mit dem erfindungsmäßig abgeänderten Design aufgelistet.

Die Leiterbahnkapazität ist nun praktisch unabhängig von der Leiterbahnnummer. Die Koppelkapazität $C_{ges}$ zwischen Leitung I und 2 beträgt hier 788 fF, zwischen Leitung 63 und 64 ist sie 798 fF. Beide Werte unterscheiden sich nur um etwas über 1 %. Diese Abweichung resultiert aus dem Unterschied zwischen der tatsächlich verwendeten und der exakten Kompensationsbreite.

Um die noch bestehenden Unterschiede der Leiterbahnkapazitäten beim Übergang von einem Chip zum nächsten (726 fF zwischen Leitung 128 und I) bzw. von einer Chiphälfte zur anderen (540 ff zwischen Leitung 64 und 65) auszugleichen, ist in einer Weiterbildung der Erfindung vorgesehen in das Layout an diesen Stellen zusätzlich "Blindleitungen" einzufügen.

Figur 3

zeigt ein Ausführungsbeispiel für diese Blindleitungen, welche hier das bei Leitung I fehlende eine Nachbarleiterteilstück L7 und das eine Nachbarbondpad L8, sowie bei Leitung 6 die fehlenden Nachbarleiterteilstücke L5, L6, L7 und das eine Nachbarbondpad L8 ersetzen sollen.

Verwendet man für die Blindleitungen die Breite des jeweils benachbarten Leiterbahnteilstückes, so läßt sich wiederum anhand der Beziehung I bei vorgewählter Länge der für einen Kapazitätsausgleich erforderliche Abstand, bzw. bei vorgewähltem Abstand die erforderliche Länge berechnen.

Der erfindungsgemäße Bildsensor erfüllt voll die Forderung, daß die Lichtempfindlichkeit, das Übersprechen zwischen benachbar ten Elementen und die Modulationsübertragung ortsunabhängig sind.

Tabelle 1

| B/R Nr. | 40/85 C4 | 49/98 C5 | 25/50 C6 | 60/180 C7 | $C_{ges}$ |
|---|---|---|---|---|---|
| 1 | 0.000 | 0.000 | 0.726 | 0.000 | 0.726 |
| 2 | 0.002 | 0.003 | 0.715 | 0.065 | 0.785 |
| 3 | 0.005 | 0.007 | 0.704 | 0.064 | 0.780 |
| 4 | 0.008 | 0.010 | 0.693 | 0.063 | 0.774 |
| 5 | 0.012 | 0.013 | 0.683 | 0.062 | 0.769 |
| 6 | 0.015 | 0.017 | 0.672 | 0.061 | 0.764 |
| 7 | 0.019 | 0.020 | 0.661 | 0.060 | 0.759 |
| 8 | 0.022 | 0.023 | 0.650 | 0.059 | 0.754 |
| 9 | 0.025 | 0.026 | 0.639 | 0.058 | 0.749 |
| 10 | 0.029 | 0.030 | 0.629 | 0.057 | 0.744 |
| 11 | 0.032 | 0.033 | 0.618 | 0.056 | 0.739 |
| 12 | 0.036 | 0.036 | 0.607 | 0.055 | 0.734 |
| 13 | 0.039 | 0.040 | 0.596 | 0.054 | 0.729 |
| 14 | 0.042 | 0.043 | 0.585 | 0.053 | 0.724 |
| 15 | 0.046 | 0.046 | 0.575 | 0.052 | 0.719 |
| 16 | 0.049 | 0.050 | 0.564 | 0.051 | 0.713 |
| 17 | 0.052 | 0.053 | 0.553 | 0.050 | 0.708 |
| 18 | 0.056 | 0.056 | 0.542 | 0.049 | 0.703 |
| 19 | 0.059 | 0.059 | 0.532 | 0.048 | 0.698 |
| 20 | 0.063 | 0.063 | 0.521 | 0.047 | 0.693 |
| 21 | 0.066 | 0.066 | 0.510 | 0.046 | 0.688 |
| 22 | 0.069 | 0.069 | 0.499 | 0.045 | 0.683 |
| 23 | 0.073 | 0.073 | 0.488 | 0.044 | 0.678 |
| 24 | 0.076 | 0.076 | 0.478 | 0.043 | 0.673 |
| 25 | 0.080 | 0.079 | 0.467 | 0.042 | 0.668 |
| 26 | 0.083 | 0.083 | 0.456 | 0.041 | 0.663 |
| 27 | 0.086 | 0.086 | 0.445 | 0.040 | 0.658 |
| 28 | 0.090 | 0.089 | 0.434 | 0.039 | 0.652 |
| 29 | 0.093 | 0.092 | 0.424 | 0.038 | 0.647 |
| 30 | 0.096 | 0.096 | 0.413 | 0.037 | 0.642 |
| 31 | 0.100 | 0.099 | 0.402 | 0.036 | 0.637 |
| 32 | 0.103 | 0.102 | 0.391 | 0.035 | 0.632 |
| 33 | 0.107 | 0.106 | 0.380 | 0.035 | 0.627 |
| 34 | 0.110 | 0.109 | 0.370 | 0.034 | 0.622 |

Tabelle 1 (Fortsetzung)

| | | | | | |
|---|---|---|---|---|---|
| 35 | 0.113 | 0.112 | 0.359 | 0.033 | 0.617 |
| 36 | 0.117 | 0.116 | 0.348 | 0.032 | 0.612 |
| 37 | 0.120 | 0.119 | 0.337 | 0.031 | 0.607 |
| 38 | 0.123 | 0.122 | 0.326 | 0.030 | 0.602 |
| 39 | 0.127 | 0.125 | 0.316 | 0.029 | 0.597 |
| 40 | 0.130 | 0.129 | 0.305 | 0.028 | 0.591 |
| 41 | 0.134 | 0.132 | 0.294 | 0.027 | 0.586 |
| 42. | 0.137 | 0.135 | 0.283 | 0.026 | 0.581 |
| 43 | 0.140 | 0.139 | 0.272 | 0.025 | 0.576 |
| 44 | 0.144 | 0.142 | 0.262 | 0.024 | 0.571 |
| 45 | 0.147 | 0.145 | 0.251 | 0.023 | 0.566 |
| 46 | 0.151 | 0.149 | 0.240 | 0.022 | 0.561 |
| 47 | 0.154 | 0.152 | 0.229 | 0.021 | 0.556 |
| 48 | 0.157 | 0.155 | 0.218 | 0.020 | 0.551 |
| 49 | 0.161 | 0.158 | 0.208 | 0.019 | 0.546 |
| 50 | 0.164 | 0.162 | 0.197 | 0.018 | 0.541 |
| 51 | 0.167 | 0.165 | 0.186 | 0.017 | 0.536 |
| 52 | 0.171 | 0.168 | 0.175 | 0.016 | 0.530 |
| 53 | 0.174 | 0.172 | 0.164 | 0.015 | 0.525 |
| 54 | 0.178 | 0.175 | 0.154 | 0.014 | 0.520 |
| 55 | 0.181 | 0.178 | 0.143 | 0.013 | 0.515 |
| 56 | 0.184 | 0.182 | 0.132 | 0.012 | 0.510 |
| 57 | 0.188 | 0.185 | 0.121 | 0.011 | 0.505 |
| 58 | 0.191 | 0.188 | 0.110 | 0.010 | 0.500 |
| 59 | 0.195 | 0.191 | 0.100 | 0.009 | 0.495 |
| 60 | 0.198 | 0.195 | 0.089 | 0.008 | 0.490 |
| 61 | 0.201 | 0.198 | 0.078 | 0.007 | 0.485 |
| 62 | 0.205 | 0.201 | 0.067 | 0.006 | 0.480 |
| 63 | 0.208 | 0.205 | 0.056 | 0.005 | 0.475 |
| 64 | 0.211 | 0.208 | 0.046 | 0.004 | 0.469 |
| 65 | 0.211 | 0.000 | 0.000 | 0.000 | 0.211 |

Tabelle 2

| B/R Nr. | 59/85 C4 | 49/98 C4 | 25/50 C6 | 60/180 C7 | $C_{ges}$ |
|---|---|---|---|---|---|
| 1 | 0.000 | 0.000 | 0.726 | 0.000 | 0.726 |
| 2 | 0.004 | 0.004 | 0.715 | 0.065 | 0.788 |
| 3 | 0.013 | 0.007 | 0.704 | 0.064 | 0.788 |
| 4 | 0.022 | 0.010 | 0.693 | 0.063 | 0.788 |
| 5 | 0.030 | 0.014 | 0.683 | 0.062 | 0.788 |
| 6 | 0.039 | 0.017 | 0.672 | 0.061 | 0.788 |
| 7 | 0.048 | 0.020 | 0.661 | 0.060 | 0.788 |
| 8 | 0.056 | 0.023 | 0.650 | 0.059 | 0.789 |
| 9 | 0.065 | 0.027 | 0.639 | 0.058 | 0.789 |
| 10 | 0.073 | 0.030 | 0.629 | 0.057 | 0.789 |
| 11 | 0.082 | 0.033 | 0.618 | 0.056 | 0.789 |
| 12 | 0.091 | 0.037 | 0.607 | 0.055 | 0.789 |
| 13 | 0.099 | 0.040 | 0.596 | 0.054 | 0.790 |
| 14 | 0.108 | 0.043 | 0.585 | 0.053 | 0.790 |
| 15 | 0.117 | 0.047 | 0.575 | 0.052 | 0.790 |
| 16 | 0.125 | 0.050 | 0.564 | 0.051 | 0.790 |
| 17 | 0.134 | 0.053 | 0.553 | 0.050 | 0.790 |
| 18 | 0.143 | 0.056 | 0.542 | 0.049 | 0.790 |
| 19 | 0.151 | 0.060 | 0.532 | 0.048 | 0.791 |
| 20 | 0.160 | 0.063 | 0.521 | 0.047 | 0.791 |
| 21 | 0.168 | 0.066 | 0.510 | 0.046 | 0.791 |
| 22 | 0.177 | 0.070 | 0.499 | 0.045 | 0.791 |
| 23 | 0.186 | 0.073 | 0.488 | 0.044 | 0.791 |
| 24 | 0.194 | 0.076 | 0.478 | 0.043 | 0.791 |
| 25 | 0.203 | 0.080 | 0.467 | 0.042 | 0.792 |
| 26 | 0.212 | 0.083 | 0.456 | 0.041 | 0.792 |
| 27 | 0.220 | 0.086 | 0.445 | 0.040 | 0.792 |
| 28 | 0.229 | 0.089 | 0.434 | 0.039 | 0.792 |
| 29 | 0.238 | 0.093 | 0.424 | 0.038 | 0.792 |
| 30 | 0.246 | 0.096 | 0.413 | 0.037 | 0.792 |
| 31 | 0.255 | 0.099 | 0.402 | 0.036 | 0.793 |
| 32 | 0.263 | 0.103 | 0.391 | 0.035 | 0.793 |
| 33 | 0.272 | 0.106 | 0.380 | 0.035 | 0.793 |
| 34 | 0.281 | 0.109 | 0.370 | 0.034 | 0.793 |

Tabelle 2 (Fortsetzung)

| | | | | | |
|---|---|---|---|---|---|
| 35 | 0.289 | 0.113 | 0.359 | 0.033 | 0.793 |
| 36 | 0.298 | 0.116 | 0.348 | 0.032 | 0.793 |
| 37 | 0.307 | 0.119 | 0.337 | 0.031 | 0.794 |
| 38 | 0.315 | 0.123 | 0.326 | 0.030 | 0.794 |
| 39 | 0.324 | 0.126 | 0.316 | 0.029 | 0.794 |
| 40 | 0.333 | 0.129 | 0.305 | 0.028 | 0.794 |
| 41 | 0.341 | 0.132 | 0.294 | 0.027 | 0.794 |
| 42 | 0.350 | 0.136 | 0.283 | 0.026 | 0.794 |
| 43 | 0.358 | 0.139 | 0.272 | 0.025 | 0.795 |
| 44 | 0.367 | 0.142 | 0.262 | 0.024 | 0.795 |
| 45 | 0.376 | 0.146 | 0.251 | 0.023 | 0.795 |
| 46 | 0.384 | 0.149 | 0.240 | 0.022 | 0.795 |
| 47 | 0.393 | 0.152 | 0.229 | 0.021 | 0.795 |
| 48 | 0.402 | 0.156 | 0.218 | 0.020 | 0.795 |
| 49 | 0.410 | 0.159 | 0.208 | 0.019 | 0.796 |
| 50 | 0.419 | 0.162 | 0.197 | 0.018 | 0.796 |
| 51 | 0.428 | 0.165 | 0.186 | 0.017 | 0.796 |
| 52 | 0.436 | 0.169 | 0.175 | 0.016 | 0.796 |
| 53 | 0.445 | 0.172 | 0.164 | 0.015 | 0.796 |
| 54 | 0.453 | 0.175 | 0.154 | 0.014 | 0.796 |
| 55 | 0.462 | 0.179 | 0.143 | 0.013 | 0.797 |
| 56 | 0.471 | 0.182 | 0.132 | 0.012 | 0.797 |
| 57 | 0.479 | 0.185 | 0.121 | 0.011 | 0.797 |
| 58 | 0.488 | 0.189 | 0.110 | 0.010 | 0.797 |
| 59 | 0.497 | 0.192 | 0.100 | 0.009 | 0.797 |
| 60 | 0.505 | 0.195 | 0.089 | 0.008 | 0.798 |
| 61 | 0.514 | 0.198 | 0.078 | 0.007 | 0.798 |
| 62 | 0.523 | 0.202 | 0.067 | 0.006 | 0.798 |
| 63 | 0.531 | 0.205 | 0.056 | 0.005 | 0.798 |
| 64 | 0.540 | 0.208 | 0.046 | 0.004 | 0.798 |
| 65 | 0.540 | 0.000 | 0.000 | 0.000 | 0.540 |

**Ansprüche**

1. Optoelektronische Bildsensoranordnung, bei der Dünnschicht- Photodioden auf einem Substrat in Zeilen angeordnet sind und über unterschiedlich lange, parallel laufende Dünnschicht-Leiterbahnen mit auf dem gleichen Substrat angeordneten Auslesechips verbunden sind, so daß die durch das von der Bildvorlage reflektierte Licht in den Photodioden erzeugten Ladungsträger als elektrische Signale ausgelesen werden können, **dadurch gekennzeichnet,** daß zum Ausgleich der Leiterbahnkoppelkapazitäten bei unterschiedlich langen benachbarten Leiterbahnen in einem oder mehreren Leiterbahnteilstücken ihre Breiten größer oder kleiner dimensioniert sind, so daß die Summe der Koppelkapazitäten aller Teilstücke zweier benachbarter Leiterbahnen unabhängig von der Gesamtlänge stets denselben Wert besitzen.

2. Bildsensoranordnung nach Anspruch 1, **dadurch gekennzeichnet,** daß zum Ausgleich der Unterschiede der Leiterbahnkapazitäten beim Übergang von einem Auslesechip zum nächsten bzw. von einer Chiphälfte zur anderen zusätzliche Blindleitungen vorgesehen sind.

3. Bildsensoranordnung nach einem der Ansprüche 1 oder 2, **dadurch gekennzeichnet,** daß der Halbleiterkörper der Photodioden aus amorphem, wasserstoffhaltigem Silizium (a-Si:H) besteht.

# FIG 1

FIG 2

# FIG 3